**Europäisches Patentamt**

(19) **European Patent Office**

**Office européen des brevets**

(11) Veröffentlichungsnummer: **0 029 548**
B1

(12) # EUROPÄISCHE PATENTSCHRIFT

(45) Veröffentlichungstag der Patentschrift:
08.08.84

(21) Anmeldenummer: 80106957.6

(22) Anmeldetag: 11.11.80

(51) Int. Cl³: **H 01 L 29/10, H 01 L 21/225**

(54) **Verfahren zum Herstellen eines Bipolartransistors.**

(30) Priorität: 21.11.79 DE 2946963

(43) Veröffentlichungstag der Anmeldung:
03.06.81 Patentblatt 81/22

(45) Bekanntmachung des Hinweises auf die Patenterteilung:
08.08.84 Patentblatt 84/32

(84) Benannte Vertragsstaaten:
DE FR GB IT

(56) Entgegenhaltungen:
EP - A - 0 003 926
DE - A - 2 640 465
US - A - 4 111 726

IBM TECHNICAL DISCLOSURE BULLETIN, Band 22, Nr. 4, September 1979, Seiten 1467-1468, New York, U.S.A. I. ANTIPOV: "Process for separate control of intrinsic and extrinsic base doping in semiconductor device fabrication"
IBM TECHNICAL DISCLOSURE BULLETIN, Band 20, Nr. 1, Juni 1977, Seiten 146-148 New York, U.S.A. I.T. HO et al.: "Doped polysilicon diffusion source and its application in single electrode random-access memories
PATENTS ABSTRACTS OF JAPAN, Band 1, Nr. 100, 5. September 1977, Seite 3163E77, Tokyo, JP

(73) Patentinhaber: SIEMENS AKTIENGESELLSCHAFT, Berlin und München Wittelsbacherplatz 2, D-8000 München 2 (DE)

(72) Erfinder: Kranzer, Ditmar, Dr., Dipl.-Ing., Theodor-Heuss-Strasse 8, D-8011 Putzbrunn (DE)

(56) Entgegenhaltungen: (Fortsetzung)
Japanese Journ. Appl. Physics Vol. 15, (1976), S. 49-54
IEEE Journ. of Solid-State Circuits, Bd. Sc-11, Nr. 4, (1976), S. 491-495

**Beschreibung**

Gegenstand der vorliegenden Erfindung ist ein Verfahren zum Herstellen eines Bipolartransistors, insbesondere für integrierte Schaltungen, bei dem die Basis und der Emitter des Transistors durch entsprechende Umdotierung in einem Teil eines die für den Kollektor des Transistors erforderliche Dotierung aufweisenden Bereiches eines einkristallinen Siliciumkörpers erzeugt und zur Erzeugung der den Emitter lateral umgebenden äußeren Basis und zur Erzeugung der unterhalb des Emitters anzuordnenden inneren Basis unterschiedliche Dotierungsprozesse angewendet werden.

Ein solches Verfahren ist in der US-PS 4 111 726 bzw. in »IBM Techn. Discl. Bull., Vol. 22 No. 4 (Sept. 1979) S. 1467 und 1468 beschrieben. Es führt zu schnelleren Transistoren im Vergleich zu Transistoren mit einer in einem einzigen Dotierungsschritt hergestellter Basis, da man die Dotierung der äußeren Basis merklich stärker als die der inneren Basis einstellen kann.

Es ist nun Aufgabe der Erfindung, ein Verfahren anzugeben, welches die Herstellung von besonders schnellen Transistoren ermöglicht.

Hierzu wird gemäß der Erfindung das genannte Verfahren derart ausgestaltet, daß zunächst der die für den Kollektor des Transistors erforderliche Dotierung aufweisende einkristalline Siliciumbereich mittels einer undotierten polykristallinen Siliciumschicht und diese unter Zwischenfügung einer $SiO_2$-Schicht mittels einer Siliciumnitridschicht abgedeckt wird, daß dann die Siliciumnitridschicht mit einer Photolackmaske versehen und diese — für den nun folgenden ersten Implantationsschritt als Implantationsmaske zu verwendende — Photolackmaske derart ausgestaltet wird, daß sie eine vom Ort des späteren Emitters mit lateralem Abstand angeordnete Öffnung zur Siliciumnitridschicht aufweist und im übrigen die Siliciumnitridschicht oberhalb des für die Erzeugung des Transistors vorgesehenen einkristallinen Siliciumbereiches völlig abdeckt, daß dann durch den ersten Implantationsschritt durch die besagte Öffnung der Photolackschicht und durch die Siliciumnitridschicht an dieser Stelle der für die Dotierung der Kontaktzone der Basiszone erforderliche Dotierungsstoff in den am Ort der Öffnung in der Photolackmaske liegenden Teil der polykristallinen Siliciumschicht eingebracht wird, daß dann die Photolackmaske entfernt und die polykristalline Siliciumschicht durch lokale Entfernung der sie abdeckenden Siliciumnitridschicht und $SiO_2$-Schicht lediglich dort für den nun folgenden zweiten Implantationsprozeß freigelegt wird, wo der nicht mit der Basiskontaktierungsstelle identische Rest der äußeren Basis vorgesehen ist, daß dann der für die Dotierung dieses Restes der äußeren Basis erforderliche Dotierungsstoff durch den zweiten und unter Verwendung des noch vorhandenen Teils der Siliciumnitridschicht als Implantationsmaske durchzuführenden Implantationsprozeß in den nicht mehr von der Siliciumnitridschicht abgedeckten Teil der polykristallinen Siliciumschicht eingebracht wird, daß anschließend an den zweiten Implantationsprozeß während einer thermischen Oxydation unter Anwendung des noch vorhandenen Teils der Siliciumnitridschicht als Oxydationsmaske die nicht von diesem Teil der Siliciumnitridschicht abgedeckten Teile der polykristallinen Siliciumschicht in $SiO_2$ umgewandelt und gleichzeitig aus ihr unter Entstehung der gesamten äußeren Basis Dotierungsstoff in den darunterliegenden Teil des einkristallinen Siliciumbereiches zum Eindiffundieren gebracht wird, daß dann die für die Erzeugung der Emitterzone vorgesehene Stelle der einkristallinen Siliciumoberfläche von dem sie abdeckenden Teil der Siliciumnitridschicht und der $SiO_2$-Schicht befreit und unter Vermittlung der hierdurch freigelegten Stelle der polykristallinen Siliciumschicht und unter Verwendung des noch vorhandenen Restes der Siliciumnitridschicht sowie der während der thermischen Oxydation entstandenen $SiO_2$-Schicht als Maske sowohl der für die Dotierung der inneren Basis erforderliche erste Dotierungsstoff als auch der für die Dotierung des Emitters erforderliche zweite Dotierungsstoff gemeinsam in den hierfür vorgesehenen Teil der polykristallinen Siliciumschicht implantiert werden, wobei die beiden Dotierungsstoffe unterschiedliche Diffusionsgeschwindigkeiten im monokristallinen Siliciumbereich aufweisen, und anschließend aus der polykristallinen Siliciumschicht unter gleichzeitiger Entstehung der inneren Basiszone und der Emitterzone in den angrenzenden Teil des monokristallinen Bereiches eindiffundiert werden.

Dem gegenüber ist in der US-PS 4 111 726 nur ein Verfahren beschrieben, bei dem ohne Verwendung einer polykristallinen Siliciumschicht zunächst der die äußere Basis bildende Dotierungsstoff, daraufhin der den Emitter bildende Dotierungsstoff und zuletzt der die innere Basis bildende Dotierungsstoff durch Ionenimplantation — und zwar unmittelbar in den den Transistor bildenden monokristallinen Halbleiterbereich eingebracht wird. Dabei wird als Dotierungsstoff für den Emitter Arsen verwendet. Unmittelbar nach der Implantation des Emitterdotierungsstoffes ist dann eine thermische Behandlung zwecks Ausheilung der durch die Implantation bedingten Kristallstörungen erforderlich, bevor die Implantation des für die innere Basis erforderlichen Dotierungsstoffes erfolgt. Dies ist deswegen notwendig, weil andernfalls undefinierte Dotierungsverhältnisse, vor allem in der inneren Basis, die Folge wären.

Bei dem in »IBM Techn. Discl. Bull. Vol. 22 No. 4 September 1979, S. 1467 und 1468, beschriebenen Verfahren zur Herstellung eines Bipolartransistors wird ebenfalls zuerst die äußere Basis durch Implantation erzeugt, woraufhin der für die Entstehung der inneren Basis und des Emitters erforderliche Dotierungsstoff ebenfalls

durch Ionenimplantation in den für die Herstellung des Transistors vorgesehenen und die Dotierung der Kollektorzone aufweisenden einkristallinen Halbleiterbereich unmittelbar eingebracht wird. Dabei wird bei den beiden letzten Implantationsprozessen die gleiche Implantationsmaske verwendet. Ein den implantierten Dotierungsstoff zwischenspeichernder polykristalliner Halbleiterbereich ist in den beiden Vorveröffentlichungen nicht angegeben. Auch hier ist unmittelbar nach jeder Implantation ein Temperaturprozeß erforderlich, um die durch die Implantation bedingten Kristallstörungen zu beseitigen, da sonst unkontrollierbare Dotierungsinhomogenitäten, vor allem in der inneren Basis, auszugleichen sind.

In der Literaturstelle »Siemens Forsch.- u. Entwickl.-Ber. Bd. 5 (1976) Nr. 6, S. 353—359« ist darauf hingewiesen, daß durch Ionenimplantation erzeugte Emitter hinsichtlich ihres elektrischen Verhaltens hinter den Erwartungen erheblich zurückbleiben. Es ist deshalb dort ein Verfahren angegeben, bei dem die für die Aufnahme der Emitterdotierung vorgesehene Oberfläche des monokristallinen Halbleiterbereichs zunächst mit einer undotierten polykristallinen und die Größe des Emitters definierenden polykristallinen Siliciumschicht abgedeckt wird und dann der Dotierungsstoff durch die polykristalline Siliciumschicht hindurch in den darunterliegenden monokristallinen Halbleiterbereich eingebracht wird. Dabei kann die polykristalline Siliciumschicht durch Ionenimplantation mit dem Dotierungsstoff versehen sein, der dann durch thermische Diffusion aus der polykristallinen Siliciumschicht in das monokristalline Halbleitermaterial (Silicium) eingebracht wird. Das Verfahren führt zur Entstehung von sehr flachen Emitterzonen, wenn man die Diffusionszeit entsprechend kurz bemißt.

Schließlich ist in der Europäischen PS 3 926 ein Verfahren zur Herstellung eines MOS-Feldeffekttransistors beschrieben, der vom n-Kanaltyp ist und bei dem der n-dotierte Sourcebereich im Gegensatz zum Drainbereich von einer höher dotierten Zone, vor allem im Kanalbereich, begrenzt ist. Um eine solche Struktur zu erreichen wird der zur Erzeugung des MOS-FET's vorgesehene Oberflächenbereich eines p-leitenden monokristallinen Siliciumplättchens zunächst mit einer polykristallinen Siliciumschicht abgedeckt, die mit Arsen hochdotiert ist. Dann wird in diese polykristalline Siliciumschicht unter Beschränkung auf den oberhalb der späteren Sourcezone liegenden Bereich durch Ionenimplantation zusätzlich Bor eingebracht. Dann werden die sich nicht oberhalb des zu erzeugenden Source- und Drainbereichs befindlichen Teile der polykristallinen Siliciumschicht durch Ätzen entfernt und dann der für die Erzeugung von Source- und Drain erforderliche Dotierungsstoff durch entsprechende Wärmebehandlung aus den noch vorhandenen Teilen der polykristallinen Siliciumschicht in das darunterliegende einkristalline Silicium zum Eindiffundieren gebracht. Dabei entsteht spontan an dem die Sourcezone begrenzenden pn-Übergang ein höher dotierter Grenzbereich infolge der im Vergleich zu der von Arsen höheren Diffusionsgeschwindigkeit des zum Teil in der polykristallinen Siliciumschicht anwesenden Bors. Es handelt sich hier um die Herstellung eines speziellen MOS-Feldeffekttransistors, wie er z. B. in der US-PS 3 631 310 beschrieben ist. Für die Herstellung eines Bipolartransistors ist hingegen das in der Europäischen PS 3 926 beschriebene Verfahren ersichtlich ungeeignet.

Das erfindungsgemäße Verfahren führt einerseits zur Entstehung sehr rasch funktionierender Bipolartransistoren. Da bei dem erfindungsgemäßen Verfahren die Ionenimplantationen auf die zunächst undotierte polykristalline Siliciumschicht an der Oberfläche des insbesondere aus monokristallinem Silicium bestehenden Kollektorbereichs beschränkt sind, entstehen auch durch diese Implantationen keine Kristallschäden. Außerdem ist das erfindungsgemäße Verfahren trotz des geringen Aufwands bezüglich der notwendigen Maskenherstellung in der Lage, die herzustellenden Transistoren in geometrischer Beziehung, ebenso wie hinsichtlich der Dotierung sehr exakt zu bemessen. Die Tatsache, daß die kritischen Profile, nämlich die Profile des Emitterbereichs und des inneren Basisbereichs gemeinsam während des letzten Temperungsprozesses des Herstellungsverfahrens entstehen, hat den Vorteil, daß danach keine Temperaturbelastung des Halbleiterbauelements mehr erfolgt und somit keine Verbreiterung der erhaltenen Dotierungsprofile entstehen kann.

Bei dem erfindungsgemäßen Verfahren werden also zwei verschiedene Dotierungsstoffe in die zunächst undotierte polykristalline Siliciumschicht an der Oberfläche des Kollektorbereiches eingebracht und dann unter gleichzeitiger Entstehung des Emitterbereichs und der inneren Basis in den darunter liegenden Halbleiterbereich eingebracht. Für die Herstellung eines npn-Transistors verwendet man hierzu für die Emitterdotierung zweckmäßig Arsen und für die Dotierung der Basis Bor, die mit unterschiedlicher Konzentration in die polykristalline Siliciumschicht eingebracht werden können. Die unterschiedlichen Diffusionsgeschwindigkeiten der beiden Dotierungsstoffe können hierbei benutzt werden, um sehr kleine Basisweiten zu realisieren. Eine weitere Verbesserung hinsichtlich kleiner Basisweiten läßt sich erreichen, wenn man die Arsenimplantation und die Borimplantation in die Polysiliciumschicht zeitlich voneinander trennt und die beiden Dotierungsstoffe in verschiedene Tiefen der Polysiliciumschicht implantiert.

Nachfolgend wird die Erfindung anhand der Zeichnung und an Ausführungsbeispielen näher erläutert. Es zeigt

Fig. 1 ein Siliciumhalbleiterkörper, dessen Oberfläche mit einer Schichtenfolge aus Polysilicium, Siliciumdioxid und Siliciumnitrid beschichtet ist,

Fig. 2 ein Siliciumhalbleiterkörper wie Fig. 1, auf dem zusätzlich eine Fotolackmaske mit Öffnungen im Bereich der Basiskontakte angebracht ist,

Fig. 3 ein Halbleiterkörper wie Fig. 1, bei dem die Siliciumnitrid- und Siliciumoxidschichten bis auf die Bereiche der Basis-Emitter- und Kollektorkontakte entfernt sind,

Fig. 4 ein Halbleiterkörper wie Fig. 3, der einer thermischen Oxidation ausgesetzt wurde,

Fig. 5 ein Halbleiterkörper wie in Fig. 4, bei dem die Siliciumnitrid- und die Siliciumdioxidschichten in den Bereichen des Kollektor- und Emitterkontaktes entfernt sind.

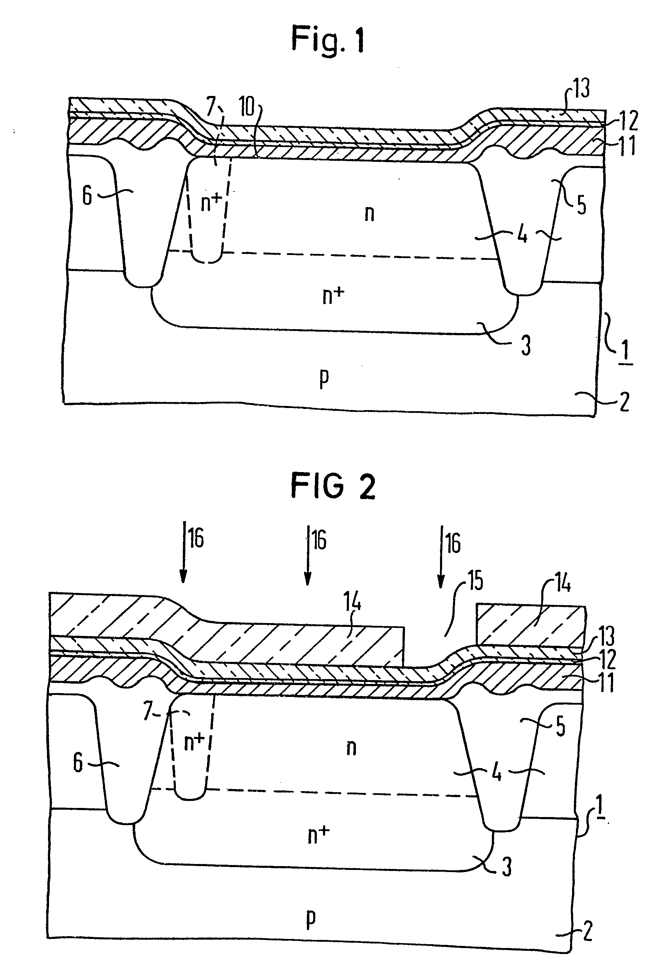

Fig. 1 zeigt einen Halbleiterkörper 1, bestehend aus einem p-dotierten Halbleitersubstrat 2, in das ein n±-dotierter Bereich 3 eindiffundiert ist und das mit einer n-dotierten epitaktisch abgeschiedenen Siliciumschicht 4 versehen ist. In die n-dotierte Siliciumschicht 4 sind Isolatorbereiche 5, 6, z. B. bestehend aus Siliciumdioxid oder aus undotiertem Polysilicium, zum Zwecke der Isolation von benachbarten Bauelementen in die n—-dotierte Siliciumschicht 4 so eingebracht, daß sie diese ganz durchsetzen und bis in das p-dotierte Halbleitersubstrat 2 bzw. den n±-dotierten Bereich 3 hinabreichen und somit eine Isolierwanne für einen darin zu bildenden Transistor erzeugen. Die Funktion der Isolatorbereiche 5, 6 kann jedoch auch durch geeignet angebrachte pn-Wände ersetzt werden, die ebenfalls die n-dotierte Siliciumschicht durchsetzen und mit dem p-dotierten Halbleitersubstrat 2 eine Wanne zur Isolation benachbarter Bauelemente bilden. Ein Bauelement, das pn-Isolationswände verwendet, ist z. B. aus Siemens Forsch. u. Entw. Ber. Bd. 5 (1976) Nr. 6, »Modern Bipolar Technology for High-Performance ICs«, Fig. 1a entnehmbar und kann anstelle der in Fig. 1 bis Fig. 5 dargestellten Halbleiterkörper analog behandelt werden, so daß entsprechende erfindungsgemäße Transistoren danach wie nach demjenigen in Fig. 1 bis 5 dargestellten Ausführungsbeispiel erhalten werden können. Dasselbe gilt auch für die Herstellung von bipolaren Transistoren nach dem Verfahren wie es in Panousis, P. T.; Pritchett, R. L.: GIMIC-O-A Low Cost Non-Epitaxial Bipolar LSI Technology Suitable for Application to TTL Circuits, Internat. Electr. Dev. Meeting, Washington 1974, Abstr. 22/4, pp. 515—518 beschrieben ist, bei dem anstelle der »Buried-Layer-Diffuison« und Epitaxialschicht eine Kollektorwanne mittels Diffusion oder Implantation erzeugt wird. Zum Zwecke der Kollektorkontaktierung ist ein n±-dotierter Bereich 7 von der Halbleiteroberfläche 10 durch die n-dotierte Siliciumschicht 4 bis in den n±-dotierten Bereich hineinragend angebracht. Auf der Halbleiteroberfläche 10, die von evtl. verbliebenen Nitrid- und Oxidresten vorangegangener Prozesse zunächst befreit wurde, sind der Reihe nach eine zunächst undotierte Polysiliciumschicht 11, eine Siliciumdioxidschicht 12 und eine Siliciumnitridschicht 13 abgeschieden.

In Fig. 2 bis 5 sind alle Teile, die mit Teilen aus Fig. 1 übereinstimmen, mit den gleichen Bezugszeichen wie in Fig. 1 belegt und werden deshalb nicht nochmals beschrieben.

Fig. 2 stellt einen Halbleiterkörper 1 wie in Fig. 1 beschrieben dar, bei dem auf der Silicium-Nitridschicht 13 eine Fotolackschicht 14 abgeschieden ist. In die Fotolackschicht 14 ist mittels fotolithographischer Verfahren eine Öffnung 15 im Bereich der vorgesehenen Basiskontakte angebracht. Diese Öffnung 15 ist etwas größer als der dort vorgesehene Basiskontakt des erfindungsgemäßen Transistors. Die Pfeile 16 deuten eine Borimplantation mit einer Teilchenenergie an, die die Fotolackschicht 14 nicht durchdringt, die Siliciumnitridschicht 13 und die Siliciumoxidschicht 12 jedoch bis hinein in die Polysiliciumschicht 11 durchdringt. Diese Borimplantation bewirkt nach einem späteren thermischen Eindiffundieren der Borionen in den darunter liegenden Halbleitereinkristall, daß der äußere Basisteil des hiernach gefertigten bipolaren Transistors eine stärkere Dotierung als der innere Basisbereich aufweist und somit einen minimalen Bahnwiderstand und gleichzeitig eine gute Sperrcharakteristik der Emitterbasisdiode liefert.

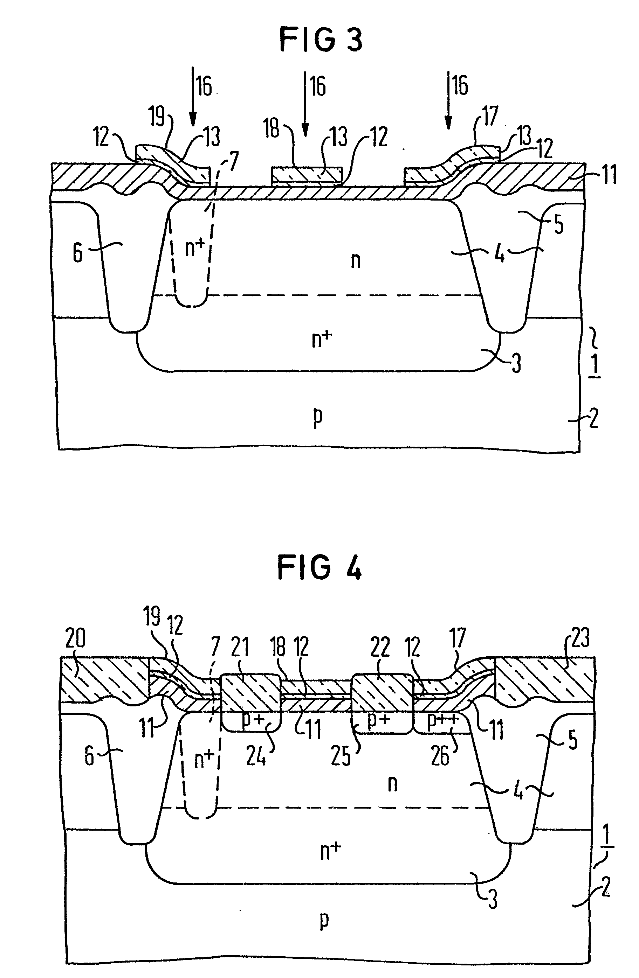

Fig. 3 stellt einen, der Fig. 1 und 2 entsprechenden Halbleiterkörper dar. Gegenüber Fig. 2 wurde die Fotolackschicht 14 entfernt und anschließend mittels eines fotolithographischen Verfahrens die Siliciumnitrid- 13 und Siliciumoxidschichten 12 bis auf die Teile 17, 18, 19 weggeätzt, an deren Stelle im späteren Verlauf des Verfahrens der Reihe nach die Basiskontakte, die Emitterkontakte und die Kollektorkontakte gebildet werden sollen. Anschließend erfolgt wiederum eine Borimplantation, angedeutet durch die Pfeile 16, mit einer derartigen Teilchenenergie, daß die freiliegenden Polysiliciumschichten mit Bor implantiert wurden, während der Halbleiterkörper selbst und die unter den Nitridschichten gelegenen Polysiliciumteile von einer Borimplantation ausgenommen sind. Diese Borimplantation bewirkt wiederum nach einem noch folgenden Temperaturschritt eine Dotierung des äußeren Basisbereichs von hiernach gefertigten bipolaren Transistoren.

Fig. 4 zeigt ein Halbleiterbauelement nach Fig. 3, bei dem eine Oxidation der freiliegenden Polysiliciumteile zum Zwecke der Strukturierung erfolgte, wobei die durch die Oxidation bedingte Erwärmung gleichzeitig ein Eindiffundieren von Bor aus der Polysiliciumschicht 11 in die darunter liegenden Halbleiterschichten bewirkt. Durch die Oxidation entstehen auf der Halbleiteroberfläche Dickoxidstrukturen 20, 21, 22 und 23. Die Bereiche 24, 25 und 26 deuten das Eindiffundieren von Bor aus dem Polysilicium in dem Halbleitereinkristall an, die Zeichen $p^+$, $p^{++}$ deuten an, daß der Bereich 26 eine stärkere Borimplantation als die Bereiche 24 und 25 aufweist.

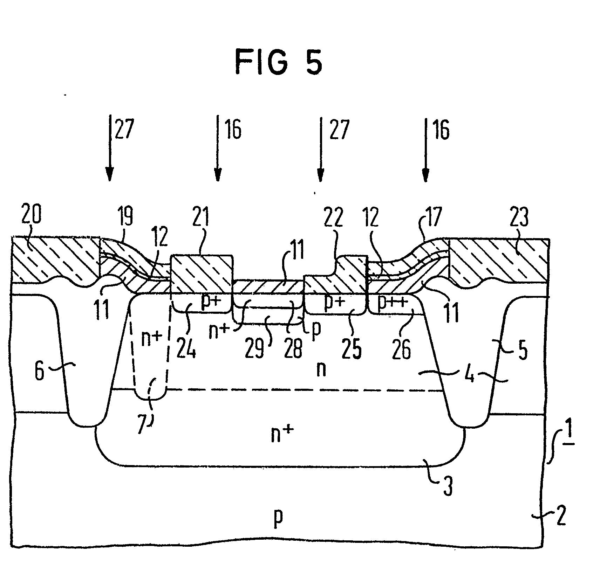

In Fig. 5 wurden gegenüber Fig. 4 mittels einer erneuten Fototechnik die Siliciumnitrid- und die Siliciumoxidschichten an den Teilen 18 und 19 entfernt, während diese Schichten an dem Teil 17 erhalten bleiben. An den vorgesehenen Basis- und Emitterkontaktstellen wurden somit alle Schichten bis auf die Polysiliciumschicht entfernt, während der vorgesehene Basiskontakt weiterhin durch eine Siliciumoxidschicht 12 und eine Siliciumnitridschicht 13 bedeckt bleibt. Eine nachfolgende Borimplantation, angedeutet durch die Pfeile 16, und Arsenimplantation, angedeutet durch die Pfeile 27, reichert die Polysiliciumschichten 11 in den Teilen 18 und 19 mit Bor und Arsen an, während die Implantationsenergien gleichzeitig so gehalten sind, daß sie die Siliciumnitridschicht 13 und die Siliciumoxidschicht 12 sowie die Dickoxidschichten 20, 21, 22 und 23 nicht durchdringen. Außerdem werden die Implantationen so eingerichtet, daß die Arsenkonzentration wesentlich größer ist als die Borkonzentration in denjenigen Teilen der Polysiliciumschicht 11, die von der Implantation betroffen sind. Mittels thermischer Diffusion werden anschließend die in die freigelegten Siliciumschichten 11 eingebrachten Bor- und Arsenionen unter Ausnützung der unterschiedlichen Diffusionsgeschwindigkeit in verschiedene Bereiche des darunter liegenden Halbleitereinkristalls eindiffundiert, so daß der Emitterbereich 28 und der innere Basisbereich 29 entstehen. Anstelle einer gleichzeitigen Bor- und Arsenimplantation können diese Implantationen auch zeitlich getrennt und in verschiedene Tiefen der freiliegenden Polysiliciumschicht 11 eingebracht werden. Es lassen sich hierdurch besonders flache, innere Basisprofile und Emitterprofile herstellen sowie besonders kleine Basisweiten einstellen, so daß sich hiernach besonders schnelle bipolare Transistoren fertigen lassen.

Zur Fertigstellung hiernach gefertigter bipolarer Transistoren werden, nach Öffnung der Kontaktstellen, auf den dotierten Polysiliciumschichten Emitter-Basis- und Kollektorkontakte angebracht.

Erfindungsgemäße Transistoren beschränken sich nicht auf die Verwendung von Silicium. Es lassen sich vielmehr auch andere geeignete Halbleitermaterialien verwenden. Außerdem können Dotierungen so angebracht werden, daß gegenüber den Ausführungsbeispielen aus Zeichnung und Beschreibung Transistoren hergestellt werden mit Bereichen, deren Dotierung hinsichtlich p- und n-Leitfähigkeit spiegelbildlich vertauscht sind.

Nach dem erfindungsgemäßen Verfahren können besonders schnelle bipolare Transistoren gefertigt werden.

## Patentansprüche

1. Verfahren zum Herstellen eines Bipolartransistors, insbesondere für integrierte Schaltungen, bei dem die Basis und der Emitter des Transistors durch entsprechende Umdotierung in einem Teil eines die für den Kollektor des Transistors erforderliche Dotierung aufweisenden Bereiches eines einkristallinen Siliciumkörpers erzeugt und zur Erzeugung der den Emitter lateral umgebenden äußeren Basis und zur Erzeugung der unterhalb des Emitters anzuordnenden inneren Basis unterschiedliche Dotierungsprozesse angewendet werden, dadurch gekennzeichnet, daß zunächst der die für den Kollektor des Transistors erforderliche Dotierung aufweisende einkristalline Siliciumbereich (4) mittels einer undotierten polykristallinen Siliciumschicht (11) und diese unter Zwischenfügung einer $SiO_2$-Schicht (12) mittels einer Siliziumnitridschicht (13) abgedeckt wird, daß dann die Siliciumnitridschicht mit einer Photolackmaske (14) versehen und diese — für den nun folgenden ersten Implantationsschritt als Implantationsmaske zu verwendende — Fotolackmaske (14) derart ausgestaltet wird, daß sie eine vom Ort des späteren Emitters mit lateralem Abstand angeordnete Öffnung (15) zur Siliciumnitridschicht (13) aufweist und im übrigen die Siliciumnitridschicht (13) oberhalb des für die Erzeugung des Transistors vorgesehenen einkristallinen Siliciumbereichs (4) völlig abdeckt, daß dann durch den ersten Implantationsschritt durch die besagte Öffnung (15) der Fotolackschicht (14) und durch die Siliciumnitridschicht (13) an dieser Stelle der für die Dotierung der Kontaktzone (26) der Basiszone erforderliche Dotierungsstoff in den am Ort der Öffnung (15) in der Fotolackmaske (14) liegenden Teil der polykristallinen Siliciumschicht (11) eingebracht wird, daß dann die Fotolackmaske (14) entfernt und die polykristalline Siliciumschicht (11) durch lokale Entfernung der sie abdeckenden Siliciumnitridschicht (13) und $SiO_2$-Schicht (12) lediglich dort für den nun folgenden zweiten Implantationsprozeß freigelegt wird, wo der nicht mit der Basiskontaktierungsstelle (26) identische Rest (24, 25) der äußeren Basis (24, 25, 26) vorgesehen ist, daß dann der für die Dotierung dieses Restes (24, 25) der äußeren Basis erforderliche Dotierungsstoff durch den zweiten und unter Verwendung des noch vorhandenen Teils (17, 18, 19) der Siliciumnitridschicht (13) als Implantationsmaske durchzuführenden Implantationsprozeß in den nicht mehr von der Siliciumnitridschicht abgedeckten Teil der polykristallinen Siliciumschicht (11) eingebracht wird, daß anschließend an den zweiten Implantationsprozeß während einer thermischen Oxydation unter Anwendung des noch vorhandenen Teils (17, 18, 19) der Siliciumnitridschicht als Oxydationsmaske die nicht von diesem Teil der Siliciumnitridschicht abgedeckten Teile der polykristallinen Siliciumschicht (11) in $SiO_2$ (20, 21, 22, 23) umgewandelt und gleichzeitig aus ihr unter Entstehung der gesamten äußeren Basis (26, 24, 25) Dotierungsstoff in den darunter liegenden Teil des einkristallinen Siliciumbereichs (24, 25, 26) zum Eindiffundieren gebracht wird, daß dann die für die Erzeugung der Ermitterzone vorgesehene Stelle der einkristallinen Siliciumoberfläche von dem sie abdeckenden Teil (18) der Siliciumnitridschicht (13) und der $SiO_2$-Schicht (12) befreit und unter Vermittlung der hierdurch freigelegten Stelle der polykristallinen Siliciumschicht (11) und unter Verwendung des noch vorhandenen Restes (17) der Siliciumnitridschicht (13) sowie der während der thermischen Oxydation entstandenen SiO₂-Schicht (20, 21, 22, 23) als Maske sowohl der für die Dotierung der inneren Basis (29) erforderliche erste Dotierungsstoff als auch der für die Dotierung des Emitters (28) erforderliche zweite Dotierungsstoff gemeinsam in den hierfür vorgesehenen Teil der polykristallinen Siliciumschicht (11) implantiert werden, wobei die beiden Dotierungsstoffe unterschiedliche Diffusionsgeschwindigkeiten im monokristallinen Siliciumbereich aufweisen, und anschließend aus der polykristallinen Siliciumschicht (11) unter gleichzeitiger Entstehung der inneren Basiszone (29) und der Emitterzone (28) in den angrenzenden Teil des monokristallinen Bereiches (4) eindiffundiert werden.

2. Verfahren nach Anspruch 1, dadurch gekennzeichnet, daß bei der Herstellung der Dotierung des für den Transistor vorgesehenen einkristallinen Bereiches (4) dieser in einer epitaktischen Schicht an der Oberfläche eines den entgegengesetzten Leitungstyp aufweisenden monokristallinen Siliciumsubstrats (2) hergestellt und außerdem mit einer vergrabenen Zone (3) vom Leitungstyp des Kollektors versehen wird, welche eine zur Oberfläche des den Kollektor des Transistors bildenden Bereichs (4) führende und der Kontaktierung des Kollektors dienende Fortsetzung (7) erhält.

3. Verfahren nach Anspruch 1 oder 2, dadurch gekennzeichnet, daß für die Dotierung der Basiszone (26, 24, 25, 29) das Element Bor und für die Dotierung des Emitters (28) das Element Arsen verwendet wird.

4. Verfahren nach einem der Ansprüche 1 bis 3, dadurch gekennzeichnet, daß der erste und der zweite Dotierungsstoff gleichzeitig in den oberhalb des zu erzeugenden Emitters (28) befindlichen Teil der polykristallinen Siliciumschicht (11) eingebracht werden.

5. Verfahren nach einem der Ansprüche 1 bis 3, dadurch gekennzeichnet, daß der erste und der zweite Dotierungsstoff zeitlich nacheinander in die polykristalline Siliciumschicht (11) oberhalb des zu erzeugenden Emitters (28) durch je einen Implantationsprozeß eingebracht werden.

## Claims

1. A method for the production of a bipolar transistor, in particular for integrated circuits, in which the base and the emitter of the transistor are produced by appropriate redoping in a part of a zone of a monocrystalline silicon body which exhibits the doping required for the collector of the transistor, and different doping processes are used for the production of the outer base which laterally surrounds the emitter and for the production of the inner base which is to be arranged below the emitter, characterised in that first, the monocrystalline silicon zone (4) which exhibits the doping required for the collector of the transistor, is covered by an undoped polycrystalline silicon layer (11) which in turn is covered by a silicon nitride layer (13) with an interposed SiO₂-layer (12); that the silicon nitride layer is then provided with a photo-lacquer mask (14) and this photo-lacquer mask (14) (which is to be used as an implantation mask for the first implantation step which now follows) is so shaped that it has an opening (15) to the silicon nitride layer (13), which opening is laterally spaced from the location of the later emitter, and for the rest entirely covers the silicon nitride layer (13) above the monocrystalline silicon zone (4) provided for the production of the transistor; that then, in the first implantation step, through the aforementioned opening (15) in the photo-lacquer lager (14) and through the silicon nitride layer (13) at this point, the dopant required for doping the contact zone (26) of the base zone is introduced into that part of the polycrystalline silicon layer (11) arranged at the position of the opening (15) in the photo-lacquer mask (14); that the photo-lacquer mask (14) is then removed and the polycrystalline silicon layer (11) is exposed for the second implantation process which now follows, by local removal of the silicon nitride layer (13) and SiO₂-layer (12) by which it is covered, where the remainder (24, 25) of the outer base (24, 25, 26) which is not identical with the base-contacting position (26) is arranged; that, in the second implantation process which is to be carried out using the remaining part (17, 18, 19) of the silicon nitride layer (13) as implantation mask, the dopant required for doping this remainder (24, 25) of the outer base is then introduced into that part of the polycrystalline silicon layer (11) which is no longer covered by the silicon nitride layer; that after the second implantation process, during a thermal oxidation process, using the remaining part (17, 18, 19) of the silicon nitride layer as an oxidation mask, those parts of the polycrystalline silicon layer (11) which are not covered by this part of the silicon nitride layer are converted into SiO₂ (20, 21, 22, 23) and simultaneously dopant is caused to diffuse out of this layer into the underlying part of the monocrystalline silicon zone (24, 25, 26), thus forming the entire outer base (26, 24, 25); that that part of the monocrystalline silicon surface which is provided for the production of the emitter zone is then freed from that part (18) of the silicon nitride layer (13) and the SiO₂-layer (12) by which it es covered, and by means of that part of the polycrystalline silicon layer (11) which is thereby exposed and using the still existing remainder (17) of the silicon nitride layer (13) and the SiO₂-layer (20, 21, 22, 23) which has been formed during the thermal oxidation by way of mask, the first dopant required for doping the inner base (29) and also the second dopant required for doping the emitter (28) are commonly implanted into that part of the polycrystalline silicon layer (11) provided for this purpose, the two dopants having different diffusion speeds in the monocrystalline silicon zone and subsequently diffusing out of the polycrystalline silicon layer (11) into the adjoining part of the monocrystalline zone (4), simultaneously forming the inner base zone (29) and the emitter zone (28).

2. A method according to claim 1, characterised in that, in order to produce the doping of the monocrystalline zone (4) provided for the transistor, this zone is produced in an epitaxial layer on the surface of a monocrystalline silicon substrate (2) which has the opposite conductivity type, and is provided with a buried zone (3) which has the conductivity type of the collector, and with a continuation (7) which leads to the surface of the zone (4) which forms the collector of the transistor and serves to contact the collector.

3. A method according to claim 1 or claim 2, characterised in that the element boron is used to dope the base zone (26, 24, 25, 29) and the element arsenic is used to dope the emitter (28).

4. A method according to one of claims 1 to 3, characterised in that the first and second dopants are simultaneously introduced into that part of the polycrystalline silicon layer (11) which is arranged above the emitter (28) which is to be produced.

5. A method according to one of claims 1 to 3, characterised in that the first and second dopants are each introduced consecutively by means of an implantation process into the polycrystalline silicon layer (11) above the emitter (28) which is to be produced.

## Revendications

1. Procédé de fabrication d'un transistor bipolaire, notamment pour des circuits intégrés, selon lequel la base et l'émetteur du transistor sont réalisés moyennant une modification correspondante du dopage dans une partie d'une zone, possédant un dopage nécessaire pour le collecteur du transistor, d'un corps en silicium monocristallin et selon lequel on utilise des processus différents de dopage pour réaliser la base extérieure entourant latéralement l'émetteur et pour réaliser la base intérieure devant être disposée au-dessous de l'émetteur, caractérisé par le fait qu'on recouvre tout d'abord la zone de silicium monocristallin (7), possédant le dopage nécessaire pour le collecteur du transistor, au moyen d'une couche de silicium polycristallin (11) non dopée, et qu'on recouvre cette couche, moyennant l'interposition d'une couche de SiO₂ (12), par une couche de nitrure de silicium (13), qu'on pourvoit ensuite la couche de nitrure de silicium d'un masque de vernis photosensible (14) et qu'on structure de masque de vernis photosensible (14) — devant être utilisé comme masque d'implantation pour la première phase d'implantation ultérieure — de telle sorte que ce masque possède une ouverture (15) distante latéralement de l'emplacement de l'émetteur ultérieur et s'ouvrant sur la couche de nitrure de silicium (13) et qu'on recouvre par ailleurs entièrement cette couche de nitrure de silicium (13) au-dessus de la zone de silicium monocristallin (4) prévue pour la réalisation du transistor, qu'on introduit ensuite au moyen de la première phase d'implantation, à travers ladite ouverture (15) de la couche de vernis photosensible (14) et à travers la couche de nitrure de silicium (16) en cet endroit, la substance dopante nécessaire pour le dopage de la région de contact (26) de la zone de base, dans la partie de la couche de silicium polycristallin (11) constituée à l'emplacement de l'ouverture (15) ménagée dans le masque de vernis photosensible (14), qu'on élimine ensuite le masque de vernis photosensible (4) et qu'on met à nu la couche de silicium polycristallin (11) au moyen d'une élimination locale de la couche de nitrure de silicium (13) et de la couche de SiO₂ (12) recouvrant cette couche de silicium, pour le second processus ultérieur d'implantation, uniquement à l'endroit où le reste (24, 25), non identique à la zone (26) d'établissement du contact de base, de la base extérieure (24, 25, 26) est prévu, qu'on introduit ensuite la substance dopante, nécessaire pour le dopage de ce reste (24, 25) de la base extérieure, dans la partie de la couche de silicium polycristallin (11) qui n'est plus recouverte par la couche de nitrure de silicium, au moyen du second processus d'implantation, devant être mis en oeuvre moyennant l'utilisation de la partie encore existante (17, 18, 19) de la couche de nitrure de silicium (20) en tant que masque d'implantation, qu'à la suite du second processus d'implantation, pedant une oxydation thermique moyennant l'utilisation de la partie encore subsistante (17, 18, 19) de la couche de nitrure de silicium en tant que masque d'oxydation, on transforme les parties de la couche de silicium polycristallin (11), non recouverte par cette partie de la couche de nitrure de silicium, en SiO₂ (20, 21, 22, 23) et qu'on provoque simultanément la diffusion de la substance dopante à partir de cette couche de silicium dans la partie sousjacente de la région de silicium monocristallin (24, 25, 26) avec formation de l'ensemble de la base extérieure (26, 24, 25), qu'on élimine à l'emplacement de la surface monocristalline (6), prévu pour la réalisation de la zone d'émetteur, de la partie (18) recouvrant cette surface, de la couche de nitrure de silicium (13) et de la couche de SiO₂) (12) et qu'à travers l'emplacement de ce fait libéré de la couche de silicium monocristallin (11) et moyennant l'utilisation du reste encore présent (17) de la couche de nitrure de silicium (13) ainsi que la couche de SiO₂ (20, 21, 22, 23), apparue pendant l'oxydation thermique, en tant que masque, on effectue une implantion commune de la première substance dopante, nécessaire pour le dopage de la base intérieure (27), ainsi que de la seconde substance dopante nécessaire pour le dopage de de l'émetteur (28) dans la partie prévue à cet effet de la couche de silicium polycristallin (11), les deux substances dopantes possédant des vitesses de diffusion différentes dans la région de silicium monocristallin, et qu'on fait ensuite diffuser ces substances, moyennant la formation simultanée de la zone de base intérieure (29) et de la zone d'émetteur (28), dans la partie contiguë de la zone monocristalline (15).

2. Procédé suivant la revendication 1, caractérisé par le fait que lors de la réalisation du dopage de la région monocristallin (4), prévue pour le transistor, on réalise cette région dans une couche épitaxiale à la surface d'un substrat en silicium monocristallin (2) possédant le type de conductivité opposé, et on l'équipe en outre d'une zone ensevelie (3) possédant le type de conductivité du collecteur et qui reçoit un prolongement (7) aboutissant jusqu'à la surface de la région (4) formant le collecteur du transistor, et servant à établir le contact avec le collecteur.

3. Procédé suivant la revendication 1 ou 2, caractérisé par le fait qu'on utilise l'élément formé par le bore pour le dopage de la zone de base (26, 24, 25) et l'élément formé par l'arsenic pour le dopage de l'émetteur (28).

4. Procédé suivant l'une des revendications 1 à 3, caractérisé par le fait que la première et la seconde substances dopantes sont introduites simultanèment dans la partie de la couche de silicium polycristallin (11), située au-dessus de l'émetteur (28) devant être réalisé.

5. Procédé suivant l'une des revendications 1 à 3, caractérisé par le fait que la première et la seconde substances dopantes sont introduites successivement, au moyen d'un processus respectif d'implantation, dans la couche de silicium polycristallin (11) au-dessus de l'émetteur (26) devant être réalisé.

## Fig. 1

## FIG 2

## FIG 3

## FIG 4

# FIG 5